# EUROPEAN PATENT APPLICATION

(11) **EP 4 531 095 A1**
(43) Date of publication of application: **02.04.2025**
(21) Application number: 23200235.2
(22) Date of filing: 27.09.2023
(51) Int. Cl.: H01L 23/31, H01L 23/433, H01L 23/495

(54) **A SEMICONDUCTOR PACKAGE FOR A PCB**

(71) Applicant: Nexperia B.V., 6534 AB Nijmegen (NL)
(72) Inventor: Estacio, Maria Cristina, Cabuyao (PH); Subida Jr., Emmanuel, Cabuyao (PH); Silva, Richmon, Cabuyao (PH)
(74) Representative: Pjanovic, Ilija

(57) **Abstract**

There is disclosed a semiconductor package for a PCB. The semiconductor package comprises a die paddle, a die, a connector, an anchor pad and an encapsulant. The die is coupled to the die paddle. The connector is coupled to the die, the connector comprising a plurality of leads for attachment to the PCB. The anchor pad is for attachment to the PCB. The encapsulant at least partly surrounds the die. The anchor pad extends across at least part of the die.

## Description

The present invention relates to a semiconductor package for a PCB, a method of manufacturing the semiconductor package, a method of attaching the semiconductor package to a PCB, an offset support for a semiconductor package, and an integral drain clip and offset support for a semiconductor package.

Semiconductor packages, such as transistors, are manufactured as layered assemblies including components such as die paddles, dies, connectors and an encapsulant (e.g. casing). Semiconductor packages are attached to a Printed Circuit Board (PCB) by coupling leads of the connector, of the semiconductor package, to the PCB (e.g. using solder).

Semiconductor packages are typically only attached to the PCB via the leads of the connector. The soldered joints, between the leads and the PCB, and the leads themselves, may be subjected to thermal fatigue cycles, and associated plastic strain, in operation, and can be susceptible to failure if not sufficiently robust.

There exists a need to overcome the disadvantages associated with existing semiconductor assemblies, and associated methods of manufacture, whether mentioned in this document or otherwise.

According to a first aspect of the invention there is provided a semiconductor package for a PCB, comprising:
a die paddle;
a die coupled to the die paddle;
a connector coupled to the die, the connector comprising a plurality of leads for attachment to the PCB;
an anchor pad for attachment to the PCB; and
an encapsulant which at least partly surrounds the die; wherein
the anchor pad extends across at least part of the die.

The semiconductor package may be a transistor. The semiconductor package may take the form of a dual-in-line (DIL) package (e.g. having two rows of leads, each row occupying a different opposed side of the package).

The die paddle may otherwise be described as a plate of conductive material. The die paddle may be manufactured from a copper alloy or entirely from copper.

The die may be a single component or may comprise multiple constituent components. The die is preferably coupled to the die paddle using solder. The die being coupled to the die paddle may otherwise be described as the die being attached to the die paddle. The die may be a silicon chip. One die may be coupled to each die paddle.

The connector may comprise a clip. The connector may be wirebonded to the die, or coupled using any other internal connection (e.g. a ribbon band). The clip may comprise one or more leads. The connector (e.g. clip) may be described as a conductive body by which the semiconductor package is connected, or connectable, to an external electrical circuit in use. The connector (e.g. clip) may be coupled to the die paddle by virtue of being coupled to the die. Described another way, the connector may be described as being indirectly coupled to the die paddle. The clip is preferably coupled to the die by solder. The connector may be a multi-part connector. For example, the connector may comprise a drain clip, gate clip and source clip (e.g. a plurality of clips). In some embodiments the connector may not comprise the drain clip. The gate clip and source clip (for example) may be conjoined to one another when that portion of the connector is first coupled to the die. The gate and source clip may be separated during a trim, form and singulate (TFS) step of the manufacture process. In preferred embodiments, there is a single gate lead, and a plurality of source and drain leads. There is preferably one more drain lead than there is gate lead (the gate lead and source leads preferably being disposed along one side of the semiconductor package).

The plurality of leads may be displaced leads (e.g. gullwing leads, incorporating a change of direction along their extent). Displaced leads have advantageously been found to provide improved board level reliability by acting as a stress reliever when the semiconductor package is installed in an electrical circuit. The `leads' may otherwise be described as projections (e.g. projecting beyond the encapsulant). Each lead may define a respective foot.

The anchor pad may form part of an offset support. Alternatively, the anchor pad may form part of an integral drain clip and offset support. The anchor pad is preferably coupled to the die paddle (e.g. via solder). The anchor pad may be coupled to, and offset from, the die paddle. The anchor paddle is preferably attachable to the die paddle by one or more legs which extend from the anchor pad. The anchor pad is distinct from the plurality of leads of the connector for at least the following reasons. Firstly, the anchor pad has a comparatively larger surface area than each of the feet of the leads. The anchor pad also preferably lies within a footprint of the encapsulant. Described another way, unlike the plurality of leads, which at least partly extend beyond a footprint of the encapsulant (e.g. and therefore project therefrom), the anchor pad does not project from, or beyond, the encapsulant. The anchor pad therefore does not increase the overall size of the semiconductor package. The anchor pad also preferably occupies a central region of the semiconductor package in at least some embodiments. Put another way, the encapsulant extends around each of the sides of the anchor pad. In preferred embodiments the anchor pad extends across the majority of the die (e.g. over at least around 70% of the die by surface area). The anchor pad is preferably plated in a similar manner to the feet of the plurality of leads.

The encapsulant may otherwise be described as a casing or shield. The encapsulant may be described as encasing the die. The encapsulant advantageously reduces the risk of contaminants, such as moisture, penetrating into the semiconductor package. The encapsulant preferably extends between first and second major faces of the die paddle (however, at least one major face of the die paddle may remain exposed [e.g. as a thermal pad, as a heatsink]). The encapsulant may be plastic. The encapsulant may otherwise be described as being manufactured from a polymer. The encapsulant is preferably manufactured using an injection moulding process where an at least partially molten material is moulded into the desired encapsulant shape. The plastic may be a thermoplastic (e.g. a thermosetting polymer).

Advantageously, the anchor pad provides another attachment point by which the semiconductor package can be secured to a PCB. In known arrangements, the semiconductor package is only attached to the PCB via a plurality of leads, specifically feet thereof. This has been found to increase the risk that the solder joints do not pass reliability tests, particularly for top-cooled embodiments (e.g. where the die paddle is provided proximate an upper surface of the semiconductor package in use [i.e. distal the leads]). By also attaching the semiconductor package to the PCB via the anchor pad, the robustness of the connection is improved and the semiconductor package is more reliably retained on the PCB.

The anchor pad may be coupled to a drain terminal.

The anchor pad being coupled to a drain terminal may otherwise be described as the anchor pad being coupled to a drain pad. The anchor pad may be described as being coupled to the die paddle via the drain terminal.

The anchor pad may be electrically connected to the drain terminal.

The anchor pad being electrically connected to the drain terminal may otherwise be described as the anchor pad being electrically connected to the drain paid. The anchor pad may be electrically connected to one or more drain pads. The anchor pad may be described as being in electrical communication with the drain terminal.

Where the anchor pad is electrically connected to the drain terminal, the anchor pad can also be used to electrically connect the semiconductor package of a PCB in operation. Advantageously, the anchor pad thus forms part of the electrical circuit. However, in other embodiments the anchor pad may be either electrically isolated from the semiconductor package or attached to a PCB, but the PCB not having a corresponding terminal or connection for electrical communication with the anchor pad.

The anchor pad may be a solid body of material.

The anchor pad being a solid body of material may otherwise be described as the anchor pad being a continuous body of material. Put another way, the anchor pad does not incorporate any aperture or other recess. Advantageously, the anchor pad being a solid body of material provides a greater surface area by which the semiconductor package can be attached to a PCB.

The anchor pad may comprise an aperture.

The anchor pad comprising an aperture may otherwise be described as the anchor pad not being defined by a solid body of material. The anchor pad may comprise a single aperture or a plurality of apertures.

Advantageously, the anchor pad comprising an aperture provides an inspection window through which other internal components of the semiconductor package (e.g. the die and/or connector) can be viewed. For example, by incorporation of the aperture an inspection window can be defined by which an operator can check the alignment of the connector with respect to the die. The aperture thus advantageously improves the quality control process.

The anchor pad may have a substantially rectangular outer perimeter.

Substantially rectangular outer perimeter is intended to refer to an outer perimeter which is generally defined by two pairs of parallel sides. Corners of the rectangular perimeter may be filleted, and this is still considered to define a substantially rectangular outer perimeter.

The anchor pad may extend across a majority of the die.

The anchor pad extending across a majority of the die advantageously means that there is a greater surface area available on the anchor pad for attachment of the semiconductor package to the PCB. An example of the anchor pad extending across a majority of the die is the anchor pad extending across at least 70% of a surface area of the die.

One or more legs may extend from the anchor pad.

The one or more legs of the anchor pad may comprise a plurality of legs. The one or more legs be described as extending from an edge of the anchor pad. One leg may extend from each of a plurality of edges of the anchor pad. The anchor pad may take the form of a cantilever arrangement (e.g. with a single leg extending from only one side of the anchor pad) or may take the form of a bridge in which multiple legs extend from opposing sides of the anchor pad.

Advantageously, the one or more legs provide a feature by which the anchor pad can be offset from the die paddle. Described another way, the one or more legs can vertically offset the anchor pad from the die paddle. Advantageously, for a top-cooled embodiment where the die paddle is disposed proximate a top side of the semiconductor package, the anchor pad can thus be provided proximate the bottom side of the semiconductor package.

Two legs may extend from opposing sides of the anchor pad.

Two legs extending from opposing sides of the anchor pad may otherwise be described as a bridge embodiment. Advantageously, two legs extending from opposing sides of the anchor pad (e.g. one leg extending from each side) has been found to provide an improvement in the robustness of the connection of the anchor pad to the die paddle. An associated improvement of the robustness of the join between the semiconductor package and PCB more generally have been found to result. Each of the legs may be substantially identical. Alternatively, the legs or one or more legs may be different from one another. For example, one leg may be comparatively thinner in a lengthways direction than the other leg.

The one or more legs may comprise a substantially perpendicular bend.

One or more legs comprising a substantially perpendicular bend may comprise each of the plurality of legs comprising a substantially perpendicular bend. A perpendicular bend is intended to refer to a complimentary angle pair where the larger of the two angles falls within the range 60 degrees to 120 degrees.

The substantially perpendicular bend may comprise a perpendicular bend (e.g. of 90 degrees).

Incorporation of the substantially perpendicular bend has advantageously been found to improve the robustness of the attachment of the anchor pad to the semiconductor package.

The anchor pad may be integral with a drain clip.

The anchor pad being integrral with the drain clip may otherwise be described as the anchor pad forming part of an integral drain clip and offset support. The anchor pad being integral with the drain clip may be described as the anchor pad defining one or more drain leads.

According to a second aspect of the invention there is provided a method of manufacturing the semiconductor package according to the first aspect of the invention, comprising:
coupling the die to the die paddle;
coupling the connector to the die;
coupling the anchor pad to the die paddle; and
moulding the encapsulant at least partly over the die.

Coupling the connector to the die may comprise coupling a conjoined gate and source clip to the die.

Coupling the anchor pad to the die paddle may comprise coupling an integral drain clip to the die paddle.

According to a third aspect of the invention there is provided a method of attaching the semiconductor package according to the first aspect of the invention to the PCB, the method comprising:
applying solder to the plurality of leads and the anchor pad or applying solder to a plurality of positions on the PCB; and
coupling the plurality of leads and the anchor pad to the PCB to attach the semiconductor package to the PCB.

Applying solder to the plurality of leads may otherwise be described as applying solder to corresponding feet of the plurality of leads. In some embodiments solder is applied to a plurality of positions on the PCB, and the semiconductor package (e.g. the feet of the leads and the anchor pad) then placed thereon.

The method may further comprise a reflow step in which the solder is cured.

According to a fourth aspect of the invention there is provided an offset support for a semiconductor package, comprising:
an anchor pad for attachment to a PCB;
one or more legs extending from the anchor pad, the one or more legs having an attachment portion, substantially parallel to the anchor pad, for attachment to a die paddle.

According to a fifth aspect of the invention there is provided an integral drain clip and offset support for a semiconductor package, comprising:
an anchor pad for attachment to a PCB;
one or more legs extending from the anchor pad, the one or more legs having an attachment portion, substantially parallel to the anchor pad, for attachment to a die paddle; and
one or more leads defining at least part of a drain clip of the semiconductor package.

The optional and/or preferred features of each aspect of the invention as set out herein are also applicable to any other aspect of the invention where appropriate.

Embodiments of the present invention will now be described, by way of example only, with reference to the accompanying drawings in which:
Figure 1 is a perspective view of a semiconductor package according to an embodiment of the invention;
Figure 2 is an alternative perspective view of the semiconductor package of Figure 1;
Figure 3 is an end view of the semiconductor package of Figures 1 and 2;
Figure 4 is a perspective view of the semiconductor package of Figures 1 to 3 with an encapsulant omitted;
Figure 5 is a side view of the semiconductor package of Figures 1 to 4, with the encapsulant shown in a partially transparent view;
Figure 6 is a perspective view of an offset support in accordance with an embodiment of the invention, the offset support forming part of the semiconductor package of Figures 1 to 5;
Figure 7 is a plan view of the offset support of Figure 6;
Figure 8 is a side view of the offset support of Figures 6 and 7;
Figure 9 is a perspective view of an offset support according to another embodiment of the invention;
Figure 10 is a perspective view of a semiconductor package incorporating the offset support of Figure 9;
Figures 11a-i schematically illustrate a method of manufacturing the semiconductor package of Figure 10;
Figure 12 is a perspective view of a semiconductor package according to another embodiment of the invention;
Figure 13 is an alternative perspective view of the semiconductor package of Figure 12;
Figure 14 is an end view semiconductor package of Figures 12 and 13;
Figure 15 is a perspective view of the semiconductor package of Figures 12 to 14 with an encapsulant omitted;
Figure 16 is an end view of the semiconductor package of Figure 15 with the encapsulant shown in a partially transparent view;
Figures 17 and 18 are alternative perspective views of an integral drain clip and offset support according to another embodiment, forming part of the semiconductor package of Figures 12 to 16;
Figure 19 is a plan view of the integral drain clip and offset support of Figures 17 and 18;
Figure 20 is an end view of the integral drain clip and offset support of Figures 17 to 19;
Figures 21a-i schematically illustrate a method of manufacturing the semiconductor package of Figures 12 to 14;
Figure 22 is a perspective view of a semiconductor package according to another embodiment with an encapsulant omitted;
Figure 23 is an end view of the semiconductor package of Figure 22;
Figure 24 is a perspective view of a semiconductor assembly according to another embodiment of the invention with an encapsulant omitted;
Figure 25 is an end view of the semiconductor package of Figure 24.

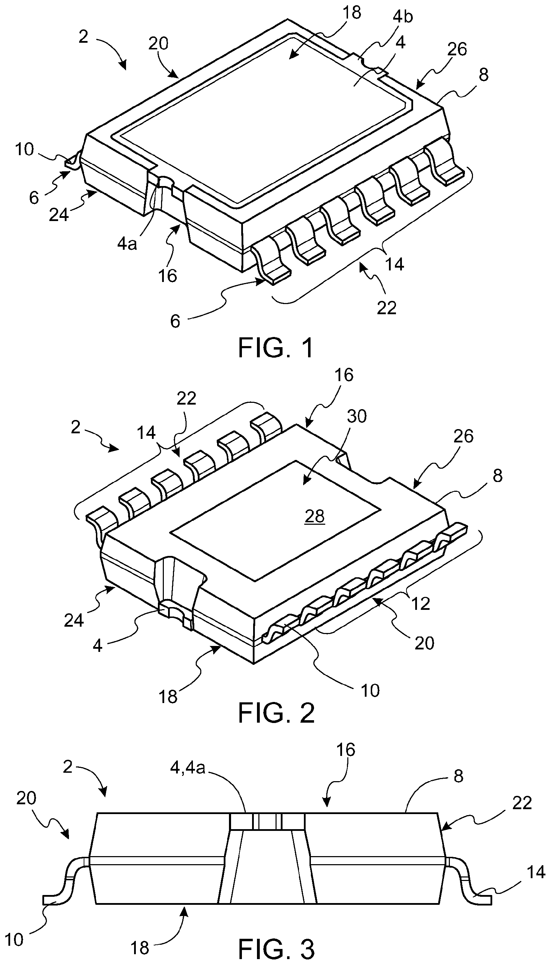

Turning to Figure 1, a perspective view of a semiconductor package 2 according to an embodiment of the invention is provided. The semiconductor package 2 is for a printed circuit board (PCB) insofar as it is attachable to a PCB to form part of an electrical circuit in operation. The semiconductor package 2 is of the form of a transistor.

As shown in Figure 1, the semiconductor package 2 comprises a die paddle 4, a plurality of leads 6 and an encapsulant 8. The semiconductor package 2 comprises further components, obscured from view in Figure 1, which will be described in detail later on in this document.

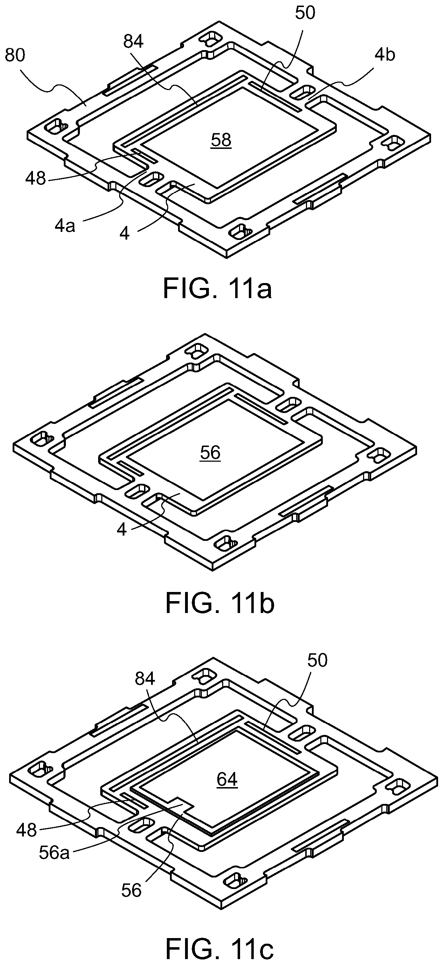

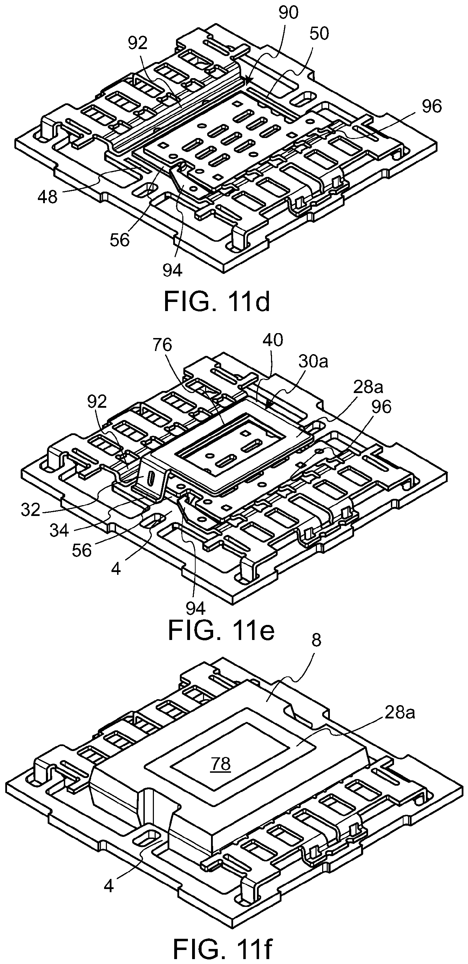

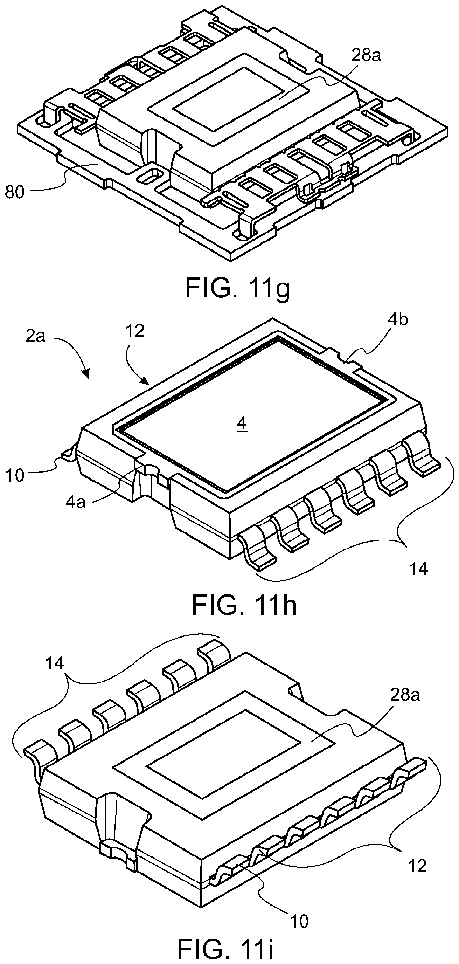

Beginning with the die paddle 4, the die paddle 4 is preferably manufactured from copper or a copper alloy, but other electronically conductive materials may otherwise be used. The die paddle 4 is a generally plate-like component, and is generally quadrangular. The die paddle 4 may be considered to form a base of sorts, in the manufacture of the semiconductor package 2, insofar as internal components of the semiconductor package 2 are built up on the die paddle 4. The die paddle 4 comprises first and second tabs 4a, 4b by which the die paddle 4 is connected to, and subsequently removed from, a lead frame during the manufacturing process (see Figures 11 a-i).

Turning to consider the leads 6, the reference numeral 6 generally denotes all of the leads. The leads 6 are for attachment of the semiconductor package 2 to a PCB.

Of the leads 6, there are three types of leads. Firstly, there is a gate lead 10 (e.g. a switching lead). Secondly, there are a plurality of source leads 12 (not visible in Figure 1 but shown in Figure 2). Finally, there are a plurality of drain leads 14. Of note, whilst there is only a single gate lead 10, there are a plurality of source leads 12 and a plurality of drain leads 14. For the semiconductor package 2 shown in Figure 1, the gate lead 10 is on the same side of the semiconductor package 2 as the source leads 12. The drain leads 14 are disposed on the opposing side of the semiconductor package 2.

All of the leads 6 are in the form of gullwing leads insofar as there is a change of direction along their extent (e.g. there is an angular change of direction). The specific function of the leads will not be described in detail here. However, the gate, source and drain leads operate in a manner which is known to the person skilled in the art of semiconductor packages.

Turning to describe the encapsulant 8, encapsulant 8 may otherwise be described as a casing. The encapsulant 8 at least partly surrounds a die which (e.g. an internal component of the semiconductor package 2, which will be described in detail below) and provides a protective functionality. Of note, the internal components of the semiconductor package 2, along with the allocation and position of the leads, will be shown and described in connection with Figures 11a-i which schematically illustrate a method of manufacturing the semiconductor package 2.

Also of note, the semiconductor package 2 shown in Figure 1 may be referred to as a top-cooled semiconductor package. This is owing to the fact that a surface of the die paddle 4, which may be referred to as a thermal pad, is exposed at a top side of the package. Put another way, the die paddle 4 is at least partly exposed at a top side of the semiconductor package 2. To aid in the explanation, in Figure 1 an underside, or first major face, of the semiconductor package 2 is labelled 16, whilst a top side, or second major face, is labelled 18. First and second sides of the semiconductor package 2, from which the gate and source leads 10, 12, and drain leads 14, respectively extend are labelled 20, 22. First and second ends of the semiconductor package 2, extending between the first and second sides 20, 22, are labelled 24, 26 respectively.

As will be appreciated from Figure 1, the encapsulant 8 only extends across part of the second major face 18 of the semiconductor package 2. A region not covered by the encapsulant 8 leaves part of the die paddle 4 exposed, which provides a cooling functionality (e.g. a heat sink).

Turning to Figure 2, an alternative perspective view of the semiconductor package 2 is provided. Whereas Figure 1 is taken generally from the perspective of the first major face 18, the perspective of Figure 2 is taken from the second major face 18. As such, features which were not visible in Figure 1 can be seen in Figure 2. The bottom side, or underside, of the semiconductor package 2 (e.g. the first major face 16), shown in Figure 2, is the side which is attached to a PCB in use.

In Figure 2, less of the die paddle 4 is visible. Only first tab 4a is visible. The second tab 4b is provided at the opposing (e.g. second end 26) end of the semiconductor package 2, but is not visible in Figure 2.

The gate lead 10 and the source leads 12 extending along the first side 20 are visible. Similarly, the drain leads 14 extending along the second side 22 are also visible. However, unlike Figure 1, and of particular relevance to the invention, an anchor pad 28 is visible.

The anchor pad 28 is for attachment to the PCB. That is to say, the anchor pad 28 is another feature, as well as the leads 10, 12, 14, by which the semiconductor package 2 can be secured to a PCB. Incorporation of the anchor pad 28 is particularly advantageous because, particularly in applications where the semiconductor package 2 is a top-cooled arrangement (e.g. like in the present case) the various leads 10, 12, 14 by which the semiconductor package 2 is attached to the PCB may be subjected to stresses at such a level that the solder joint reliability is not met. Similarly, the solder joint pads, by which the leads are connected to the PCB, may be subjected to excessively high stresses. This can result in the semiconductor package 2 failing to meet solder joint reliability requirements (e.g. not being sufficiently robustly attached to the PCB). Advantageously, by incorporating the anchor pad 28, the surface area by which the semiconductor package 2 is attached to the PCB is greatly increased. This, in turn, reduces the stresses induced in the leads 10, 12, 14 and the associated solder pads at the feet thereof. The thermal fatigue performance of the semiconductor package 2 is thus improved as a result, particularly for the gate lead. The anchor pad 28 can also advantageously provide a heatsink functionality in dissipating heat from the semiconductor package 2 by conduction.

The anchor pad 28 extends across at least part of a die (not visible in Figure 2 but will be described in detail later). Furthermore, the anchor pad 28 is contained within a footprint defined by the encapsulant 8. Described another way, advantageously the anchor pad 28 does not extend beyond the encapsulant 8, which means the overall size of the semiconductor package 2 is not increased. The anchor pad 28 also does not extend beyond points at which leads 10, 12, 14 project from the encapsulant.
As will be appreciated from Figure 2, the anchor pad 28 is not covered by the encapsulant 8. As such, the anchor pad 28 remains exposed even after a moulding process, in which the encapsulant 8 (generally a polymer, such as plastic) is moulded to form the semiconductor package 2. See also Figures 11e and 11f, which will be described in detail below.

As will be described throughout this document, other geometries, and embodiments, of pad can otherwise be used. For the anchor pad 28 shown in Figures 1 and 2, the anchor pad 28 is a solid body of material (e.g. does not incorporate an aperture) and also has a substantially rectangular outer perimeter. Similarly, anchor pad 28 extends across a majority of the die. However, these are all optional features.

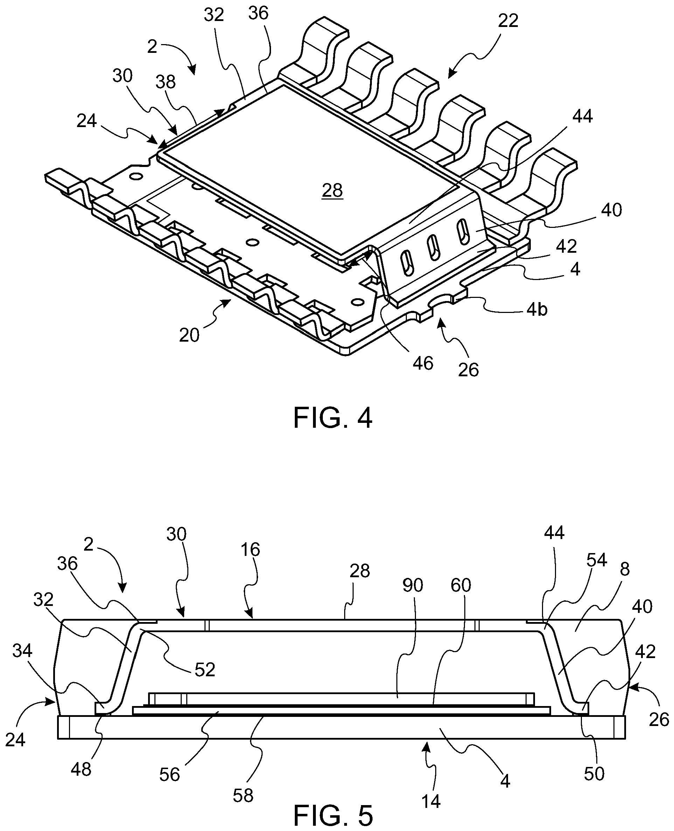

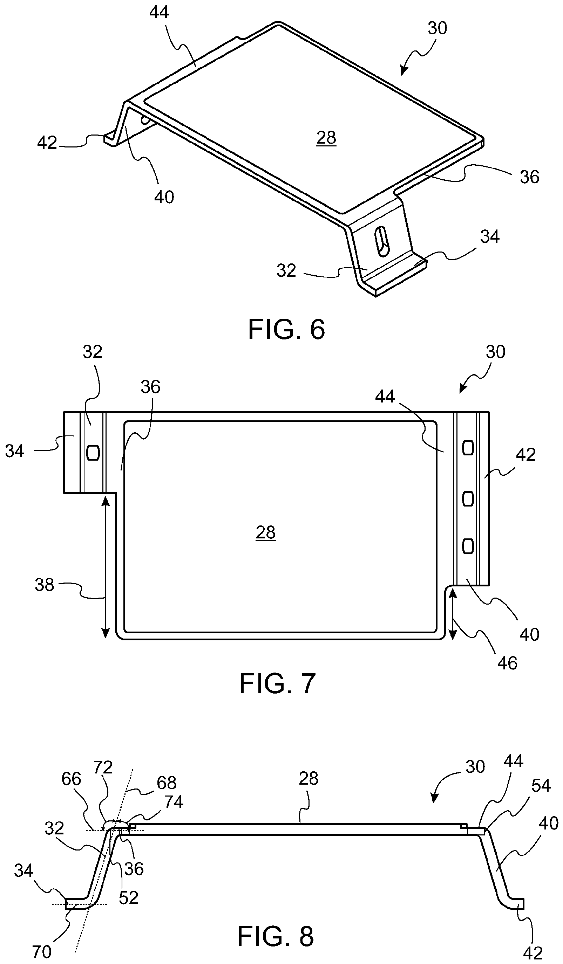

In the illustrated embodiment the anchor pad 28 forms part of an offset support 30. The offset support 30 is also shown in alternative views in Figures 4 to 8, including in isolation in Figures 6 to 8, and further detail will be provided in connection with these figures.

Although not an essential feature, in an advantageous embodiment the anchor pad 28 is coupled to a drain terminal, and is specifically electrically connected to a drain terminal. The anchor pad 28 thus forms part of the electrical circuit of the semiconductor package 2. However, this is not essential, and the mere presence of the anchor pad 28, even if not electrically connected to the drain terminal, still provides advantages in more securely retaining the semiconductor package 2 on a PCB.

Turning to Figure 3, an end view of the semiconductor package 2 is provided taken generally from the first end 24. Figure 3 shows the first tab 4a of the die paddle 4, the encapsulant 8, and the gate and drain leads 10, 14 are shown extending through/projecting from the encapsulant 8. Of note, the anchor pad 24 is not visible from the end view shown in Figure 3.

Turning to Figure 4, a perspective view of the semiconductor package 2 is provided with the encapsulant 8 omitted.

As such, more features of the offset support 30, of which the anchor pad 28 forms part, are visible. For example, in Figure 4 first and second legs 32, 40 of the offset support 30 is visible. The legs 32, 40 may otherwise be described as projections.

The first leg 32 is disposed proximate a first end 24 of the semiconductor package 2. The first leg 32 comprises a corresponding foot 34 (not visible in Figure 4) by which the leg 32, and anchor pad 28 and offset support 30 more generally, are coupled to the die paddle 4. The foot may otherwise be described as an attachment portion. The foot is substantially parallel to the anchor pad 28. This is also shown in connection with Figure 5.

Returning to Figure 4, it will be appreciated that the first leg 32 only extends along part of a corresponding first edge 36 of the anchor pad 34. Rather, a clearance 38 is provided, along the first edge 36, along which the leg 32 does not extend, to allow space for the connector beneath.

The second leg 40 is disposed proximate the second end 26 of the semiconductor package 2. The second leg 40 comprises a corresponding foot 42 by which the leg 40, and anchor pad 28 and offset support 30 more generally, are coupled to the die paddle 4. The foot may otherwise be described as an attachment portion. The foot 42 is substantially parallel to the anchor pad 28. This is also shown in connection with Figure 5.

The second leg 40 also only extends along part of the corresponding second edge 44 of the anchor pad 28. A clearance 46 is provided, along the second edge 44, along which the leg 40 does not extend, to allow space for the connector beneath.

The anchor pad 28 is preferably distributed symmetrically between the first and second sides 20, 22 of the semiconductor package. This is owing to the presence of the leads disposed along each side of the semiconductor package.

Turning to Figure 5, an end view of the semiconductor package 2 is provided with the encapsulant 8 shown in a partially transparent state with the leads 6 omitted and generally from the first side 20 as labelled on Figures 4 and 2.

As will be appreciated by the different extents of the clearances 38, 46, the second leg 40 is comparatively wider, in a lengthways direction, than the first leg 32.

Turning to Figure 5, a side view of the semiconductor package 2 is provided, and the encapsulant 8 is further provided in a partially transparent view. First and second major faces 16, 18 of the semiconductor package 2 are schematically indicated in Figure 5. The orientation of the semiconductor package 2 in Figure 5 thus corresponds to that shown in Figure 2.

The first and second legs 32, 40 are shown extending from the anchor pad 28. Furthermore, respective feet 34, 42 are also shown, disposed at ends of the legs 32, 40. Respective solder pads 48, 50, between the die paddle 4 and the first foot 34 and second foot 42 respectively are also shown. By virtue of the solder pads 48, 50, the offset support 30 is attached to the die paddle 4.

Figure 5 also demonstrates that the legs 32, 40 of the offset support 30 comprise a substantially perpendicular bend 52, 54. The (larger) angle defined between the anchor pad 28 and the legs 32, 40, corresponding to the first and second bends 52, 54, is approximately 110° in the illustrated embodiment. Substantially perpendicular bend is intended to include any complimentary angle pairing where the larger angle is between around 60° and around 120°. In some embodiments the legs may comprise a perpendicular bend insofar as the bend is equal to 90°. More detail regarding the angles is provided in connection with Figure 8.

Figure 5 also shows die 56, the die 56 being coupled to the die paddle 4. A corresponding (first) solder pad which couples the die 56 to the die paddle 4 is labelled 58. On the other side of the die 56 a (fifth) solder pad is labelled 60. A connector 90 is coupled to the die 56 via the solder pad 60.

As will be appreciated from, for example, Figure 11d, the connector 90 comprises a plurality of leads for attachment to the PCB. Specially, the portion of the connector 90 visible in Figure 5 corresponds comprises the gate and source leads 10, 12 (although neither of which is visible in Figure 5).

Advantageously, the semiconductor package 2 comprising the two legs 32, 40 extending from opposing sides of the anchor pad 28 improves the robustness of the coupling between the anchor pad 28 and the die paddle 4. In turn, when the anchor pad 28 is attached to the PCB, the overall robustness of the attachment of the semiconductor package 2 to the PCB (via the anchor pad 28 and associated feet of each of the gate, source and leads 10, 12, 14) is improved as a result.

Turning to Figure 6, a perspective view of the offset support 30 in isolation is provided.

As previously described, the offset support 30 comprises anchor pad 28 and first and second feet 32, 40 which extend from first and second edges 36, 44 of the anchor pad 28. Each of the first and second legs 32, 40 comprises a respective foot 34, 42 at an end thereof, by which the respective leg, and offset support 30 generally, are attached to the PCB. Each of the first and second legs 32, 40 further comprises one or more apertures provided therein. The apertures advantageously improve the flow of mould material (i.e. of the encapsulant 8) and provide mould locking features (which reduce the risk of delamination). The apertures thus improve the manufacture, and robustness of, the encapsulant 8.

Turning to Figure 7, a plan view of the offset support 30 is provided. The plan view thus shows each of the first and second legs, 32, 40 extending from the anchor pad 28. The clearances 38, 46 provided at each of the first and second edges 36, 44 of the anchor pad 28 (i.e. along which the first and second legs 32, 40 respectively do not extend) are also visible. Put another way, differing lengthways extents of the first and second legs 34 to 40 are shown in Figure 7.

Figure 7 also shows the first leg 32 comprising one aperture, whereas the second leg 40 comprises three (e.g. a plurality of) apertures. The apertures take the form of lozenge-shaped (e.g. oval) apertures, but other geometries could otherwise be used.

Turning to Figure 8, a side view of the offset support 30 is provided. Figure 8 therefore provides a similar view of the offset support 30 to that shown in Figure 5, but with other features of the semiconductor package omitted.

Schematically annotated on Figure 8 is a first plane 66 extending through a midpoint of a thickness at the anchor pad 28. Also labelled is a second plane 68 which extends through a midpoint of a thickness of the first leg 32, and a third plane 70 which extends through a midpoint of a thickness of the second leg 40. Each of the first, second and third planes is thus indicative of a direction of each of the anchor pad 28, first leg 32 and second leg 40 extend in. First and second complimentary angles 72, 74 are schematically annotated between the first plane 66 and the second plane 68. As will be appreciated from Figure 8, in the illustrated embodiment the first angle 72 is larger than the second angle 74. As previously described, the bend 52 is a substantially perpendicular bend. A substantially perpendicular bend is intended to mean that a larger of the first and second complimentary angles 72, 74 falls within the range 60 degrees to 120 degrees. Any angle falling outside of this range would mean that the bend is no longer substantially perpendicular. It will be appreciated that in some embodiments the bend may be a perpendicular bend, in which case the angle 72, 74 would be equal to 90 degrees. By way of an example, the first angle 72 may be between 90 and 120 degrees, and the second angle 74 may be between 60 and 90 degrees.

Although the angles are not schematically indicated for the foot 34, it will be appreciated that similar logic applies to the angular relationship between the foot 34 and the leg 32. Furthermore, it will also be appreciated that the first and third planes 66, 70 are substantially parallel to one another. This is intended to mean that an angular offset between the planes 66, 70 is less than around 5 degrees.

Although not labelled for the corresponding second leg 40, the above description also applies equally to the second leg 40. However, it will be appreciated that the angles are mirrored where appropriate.

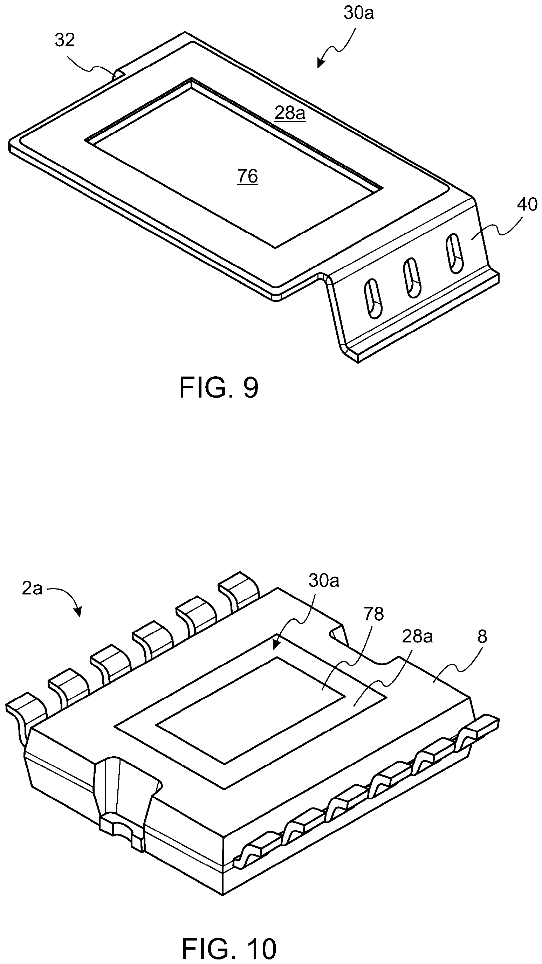

Turning to Figure 9, a perspective view of an offset support 30a according to another embodiment is provided. Of note, the offset support 30a shares many features in common with the offset support 30 described and shown in connection with Figures 4-8. As such, for brevity common features will not be described again in detail.

Briefly, like the offset support 30, the offset support 30a comprises first and second legs 32, 40 and an anchor pad 28a. A primary difference between the offset support 30a and the offset support 30 is that the anchor pad 28a comprises an aperture 76. The aperture 76 is a centrally located rectangular aperture. As such, in this embodiment the pad 28a is not a solid body of material, but instead comprises the aperture 76. The anchor pad 28a thus takes the form of generally rectangular annulus. The anchor pad 28a may otherwise be described as having a thickness or border, which extends around the aperture 76. Save for this difference, all of the other features of the offset support 30a are shared in common with the offset support 30, and the preceding description is thus equally applicable to the offset support 30a.

As will be appreciated and described in connection with later embodiments, an advantage of the support 30a is that the aperture 76 provides an inspection window through which the alignment of other components forming part of a semiconductor package incorporating the offset support 30a can be assessed. Incorporation of the aperture 76 means that an inspection window can be used while still providing all of the other associated advantages of the anchor pad 28 (e.g. improving the robustness of the connection of the semiconductor package to the PCB). In particular, the alignment of the gate clip (94 - visible in Figure 11d) is sensitive with respect to the die, and it is desirable to be able to inspect this alignment via the aperture 76.

Turning to Figure 10, a perspective view, generally of an underside of a semiconductor package 2a according to another embodiment is provided. The semiconductor package 2a incorporates the offset support 30a, but otherwise shares many features in common with the semiconductor package 2 shown and described in connection with Figures 1-3. Furthermore, the view shown in Figure 10, of the semiconductor package 2a, is very similar to that shown in Figure 2, save for the differences associated with the anchor pad 28 (28a). Accordingly, for brevity the description which is common to both embodiments will not be repeated here, and only the differences will be described in detail.

Like the description in connection with Figure 2, the underside (e.g. first major side) of the semiconductor package 2a comprises the anchor pad 28a. However, unlike the previous embodiment, owing to the presence of the aperture (76 in Figure 9) in the anchor pad 28a, a portion 78 of the encapsulant 8 also extends within the anchor pad 28a. Described another way, the aperture 76 as shown in Figure 9 is effectively filled with, or covered by, the encapsulant 8. This defines the portion 78 of encapsulant which fills the aperture. This portion 78 may be said to cap the aperture 76.

By covering the aperture 76, the portion 78 of encapsulant 8 still protects the internal components of the semiconductor package 2a in the normal way that an encapsulant 8 would. However, and as was previously described, this functionality is advantageously provided in combination with the fact that: i) the anchor pad is incorporated; and ii) inspections of the internal components of the semiconductor package 2a can be more readily conducted as part of the assembly and verification process.

Turning to Figures 11a-11i, a method of manufacturing a semiconductor package, corresponding to the semiconductor package 2a shown in Figure 10, is schematically illustrated. The method may otherwise be described as a process flow.

Beginning at Figure 11a, a lead frame 80 is shown, in a perspective plan view. The lead frame 80 is effectively a sheet of material, with material having been selectively removed, such as by stamping or etching, in order to define one or more die paddles (only one being shown in Figure 11a, and labelled 4). The lead frame 80 may otherwise be described as a common lead frame (e.g. in embodiments where the lead frame 80 defines a plurality of die paddles).

Figure 11a also shows the die paddle 4 being attached to the lead frame 80 by first and second tabs 4a, 4b. In a singulation step, in a later step of the manufacturing process, the first and second tabs 4a, 4b are severed, or cut, to detach the die paddle 4, and association semiconductor package, from the lead frame 80.

Figure 11a shows a manufacturing step beyond the lead frame 80 in isolation. In Figure 11a solder has been printed onto the die paddle 4, in multiple locations, in advance of the coupling of further features to the die paddle 4. In particular, a first (die) pad 58 occupies most of the surface area of the die paddle 4. A second (drain) pad 84 is also printed along one side of the die paddle 4. The second pad 84 is elongate, and may be described as strip-like. As will be appreciated from Figure 11d, the drain pad 84 is the solder pad to which a drain clip 92 (e.g. part of the connector 90) is coupled. Returning to Figure 11a, third and fourth pads 48, 50 are also printed, generally at either end of the second pad 84. The third and fourth pads 48, 50 are smaller than the second pad in surface area. In the illustrated embodiment the third pad 48 is also smaller than the fourth pad 50. As shown in Figure 11e, the third and fourth pads 48, 50 are the locations which correspond to the first and second feet 34, 42 of the offset support 30a (see also Figure 5). As such, the offset support 30a is coupled to the die paddle 4 via the third and fourth pads 48, 50.

The step shown in Figure 11a may be described as a solder layer being printed on the, or each, die paddle. The solder layer may be applied by a screen printing process. The solder layer may be described as being dispensed or applied to the die paddle 4. The solder layer is preferably applied to all of the die paddles (if appropriate) in this single process step.

Figure 11b shows a further step in which the die 56 is coupled to the die paddle 4. Specifically, the die 56, which comprises a semiconductor material, is placed onto the first pad 58. Coupling the die 56 may be described as the die 56 being placed onto the solder layer 58. As described above, the solder layer 58 is in turn, disposed on the die paddle 4. In the die coupling step of Figure 11b, each of a plurality of die paddles is provided with a die. Of note, the second to fourth pads 84, 48, 50, are still exposed in this step, and the die 56 is not attached to these pads. Second to fourth pads 84, 48, 50 are thus still available, or 'vacant', following attachment of the die 56.

Turning to Figure 11c, a further step of the process is shown in which another layer of solder is printed, this time onto the die 56. The solder layer 64 may otherwise be described as being printed onto, or applied to, the die 64. Like the step shown in Figure 11a, solder is applied to each die (for a leadframe comprising a plurality of die paddles). Like in Figure 11a, the solder layer 64 is preferably applied to all of the dies in this single process step. The solder layer is preferably applied to all of the dies simultaneously. The solder layer may be applied to the dies in a consecutive manner (e.g. die by die). The solder layer 64 may be described as a fifth pad. As described in connection with Figure 11b, the second to fourth pads 84, 48, 50, are still exposed in this step, and the die 56 is not attached to these pads. Second to fourth pads 84, 48, 50 are thus still available, or 'vacant', following attachment of the die 56.

Turning to Figure 11d, a further step of the process is shown in which a connector 90 is coupled to the subassembly. The connector 90 comprises a drain clip 92, a gate clip 94 and a source clip 96 in the illustrated embodiment. As shown in Figure 11d, the drain clip 92 is separate from the gate and source clips 94, 96. Accordingly, the connector 90 may be described as a multi-part connector comprising a first part (e.g. the drain clip 92) and a second part (e.g. the conjoined gate and source clips 94, 96). The gate and source clips 94, 96 are in a conjoined state in Figure 11d, but are separated from one another in a subsequent step.

Beginning with the drain clip 92, the drain clip 92 is coupled to the die paddle 4 via the second pad 84 (see Figures 11a-c). The gate clip 94 portion of the conjoined clip is coupled to the die 56 via an exposed portion of the die 56 labelled 56a in Figure 11c. The source clip 96 portion of the conjoined clip is coupled to the die 56 via the fifth pad 64 (see Figure 11c).

Projections extending from each of the clips 92, 94, 96 as shown in Figure 11d define the leads 10, 12, 14 as shown in Figures 11h and 11i. Third and fourth pads 48, 50 are still exposed, or `vacant', following attachment of the drain clip 92 in this embodiment.

Turning to Figure 11e, a step of the manufacturing process is shown in which the offset support 30a is attached. The offset support 30a is coupled to the die paddle 4 via the third and fourth pads 48, 50 (not labelled in Figure 11e, but see Figure 11d). Specifically, first and second feet 34, 42 (42 not visible in Figure 11e) of the first and second legs 32, 40 are placed onto third and fourth pads 48, 50 on the die paddle 4. The offset support 30a is thus attached to the subassembly. Of note, as shown in Figure 11e, the aperture 76 provides a window through which the source clip 96 alignment, and indeed alignment of other `internal' components of the subassembly can be observed. The anchor pad 28a extends across a majority of the die 56, and may be described as extending over, and across, the source clip 96. The anchor pad 28a is also vertically offset from the die paddle 4 by virtue of the legs 32, 40 of the offset support 30a. As shown in Figure 11e, it is desirable that the anchor pad 28a does not overlap the gate clip 94. This is for at least the reason that the alignment of the gate clip 94 is particularly sensitive with respect to the die 56. Furthermore, this reduces the risk of exposed copper after moulding the encapsulant.

Turning to Figure 11f, a moulding step of the process is shown. In Figure 11f encapsulant 8 is moulded over the die 56 (and various other components). The moulding process occurs by way of injection moulding. For completeness, the mould/mould cavity is not shown in Figure 11f. The anchor pad 28a remains visible, or exposed, even after moulding occurs. Accordingly, the aperture 76 through the anchor pad 28a, as shown in Figure 11e, is 'filled' with the moulded material such that the portion 78 of encapsulant is defined.

In Figure 11g a deflash and plating step is shown. In the illustrated embodiment, exposed copper features, such as projections of the various clips, the anchor pad 28a etc. are plated to improve robustness and reduce the risk of corrosion in this step. The plating also improves the adherence of solder to the leads. The leadframe 80, more generally, is also plated. The components are generally plated with Tin (Sn).

Figure 11h shows a step of the process after a trim, form and singulation (TFS) step has occurred. TFS is a (multi-stage) punching process in which dambars between leads are removed, the leads are defined, and the leads are then formed (into gullwing [e.g. displaced] leads). TFS also singulates the semiconductor package 2a (e.g. separates it from the surrounding leadframe 80 of the preceding Figures). The gate lead 10, source leads 12 and drain leads 14 are labelled in Figure 11h.

Figure 11i shows the semiconductor package 2a from an underside perspective view. In the final, singulated semiconductor package 2a, the anchor pad 28a remains exposed (albeit plated). Furthermore, the anchor pad 28a lies in the same plane as feet of the various leads.

During one or more of the above steps, or at an intermittent step therebetween, one or more reflow steps in which the solder layers, applied in steps shown in Figures 11a and 11c, undergo a reflow soldering process, may occur. Specifically, the semiconductor package 2a, or subassembly thereof, ma be subjected to a controlled elevated temperature, such as being passed through a reflow oven or passed under an infrared lamp, to create permanent soldered joints to 'cure' the semiconductor package 2a.

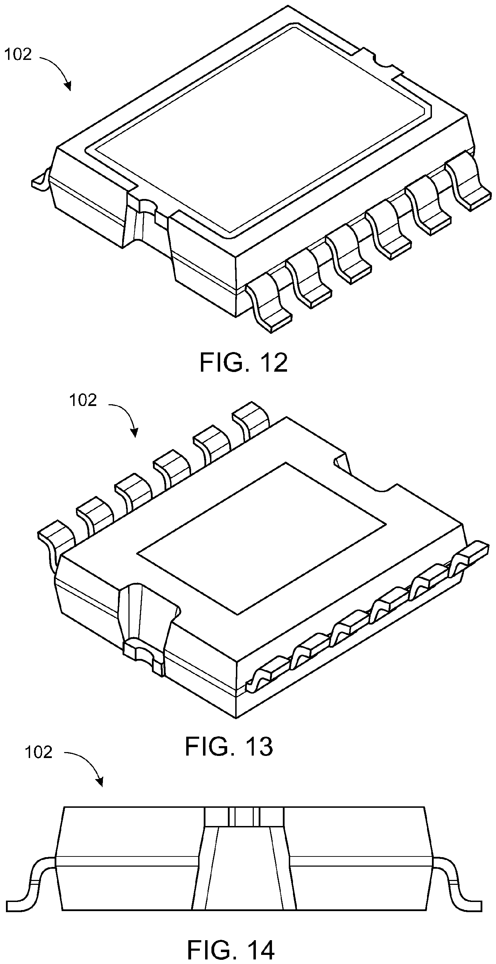

Turning to Figures 12 to 14, two perspective, and one end, views of a semiconductor package 102 according to another embodiment are provided. Given the near identical nature of the semiconductor package 102 shown in Figures 12-14 to the semiconductor package 2 shown in Figures 1-3, no further description will be provided in connection with these Figures. The description in connection with Figures 1-3 applies equally here.

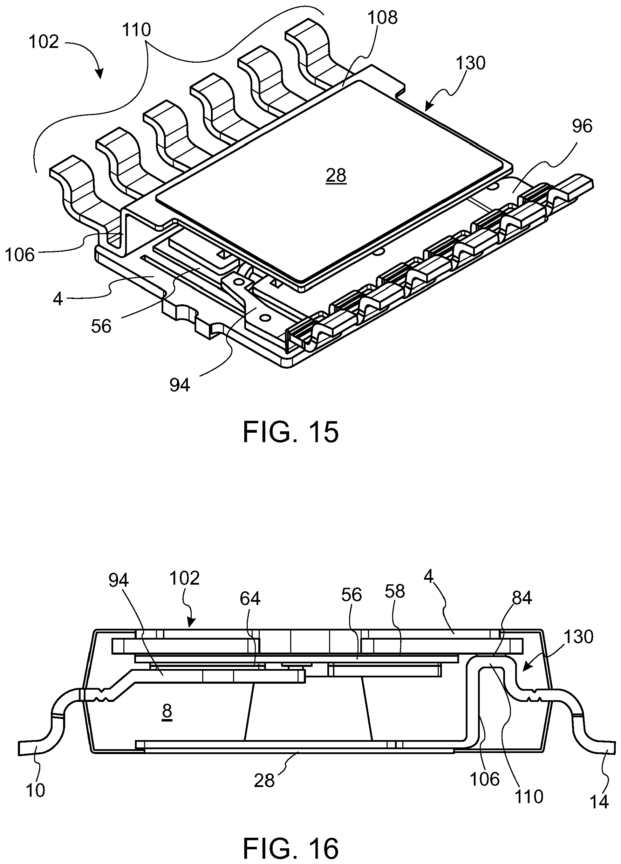

Turning to Figure 15, perspective view of the semiconductor package 102 with an encapsulant 8 omitted is shown. Like the perspective view shown in Figure 4, for the preceding embodiment, the view shown in Figure 15 shows the die paddle 4, a die 56 coupled to the die paddle and gate and source clips 94, 96 coupled to the die 56. Also like the previous embodiments, the semiconductor package 102 comprises anchor pad 28. However, unlike the previous embodiments, the anchor pad 28 forms part of an integral drain clip and offset support 130. As suggested by the name, as well as providing the offset support functionality previously described (e.g. an additional attachment point for securing the semiconductor package 102 to a PCB), the integral drain clip and offset support 130 also provides the functionality of a drain clip. Described another way, the integral support 130 also comprises a plurality of leads 110 which define drain leads of the semiconductor package 102. The plurality of leads 110 are specifically displaced leads (e.g. gullwing leads).

A further distinction of the anchor pad 28 lies in the way in which it is coupled to the semiconductor package 102. Whereas in the previous embodiment first and second legs extended from opposing edges of the anchor pad 28, the integral support and drain clip 130 takes the form of a cantilever. That is to say, in the embodiments shown in Figure 15, a single leg 106 extends from an edge 108 of the anchor pad 28. As such, the anchor pad 28 is supported entirely by the one leg 106. However, additional legs could otherwise be incorporated. Furthermore, whereas in the previous embodiment the plurality of legs extend from short sides of the anchor pad, in this embodiment the leg 106 extends from a single long edge 108 of the anchor pad 28. As such, the anchor pad 28 is electrically connected, and coupled to, a drain terminal (e.g. drain pad) of the semiconductor package 102.

Turning to Figure 16, an end view of the semiconductor package 102 is provided. Furthermore, the encapsulant 8 is shown in a partially transparent view.

Save for the differences described above, the view of Figure 16 shares many features in common with that shown in Figure 5 (other than for being in a reversed orientation). For example, the die 56 is coupled to the die paddle 4 by a first die solder pad 58. The gate lead 10 is defined by gate clip 94, the gate clip 94 being coupled to the die 56.

However, unlike the previous embodiment Figure 16 shows the leg 106 of the integral clip and support 130 extending at a perpendicular angle to the anchor pad 28. Furthermore, a U-shaped portion 110 at an end of the leg 106 defines a foot by which the integral clip and support 130 is coupled to the die paddle 4. The drain lead(s) 14 extend from the U-shaped portion 110.

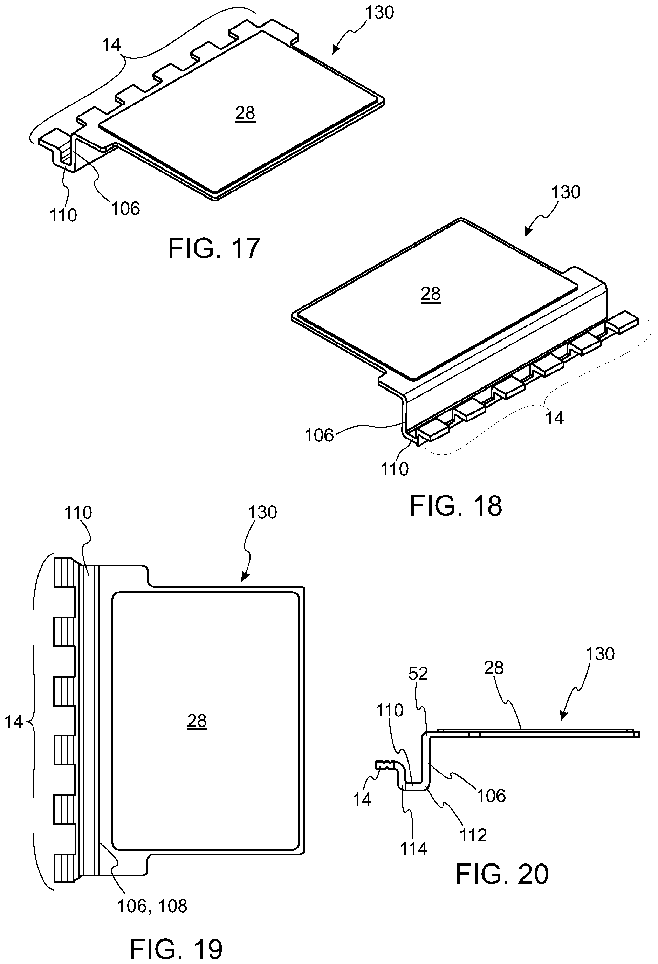

Turning to Figures 17 and 18, two perspective views of the integral drain clip and offset support 130, shown in isolation, are provided.

As described in connection with Figures 15 and 16, the integral clip and offset support 130 takes the form of a cantilever in which the single leg 106 extends from the drain pad 28, specifically a long edge 108 thereof, at a perpendicular angle. A U-shaped portion 110 defines a foot by which the integral support 130 is attachable to a semiconductor package. Extending from the opposing side of the U-shaped portion 110 are a plurality of drain leads 14. The drain leads 14 define a drain clip of the semiconductor package.

In this embodiment the anchor pad 28 takes the form of a solid body of material in that there is no aperture through the anchor pad 28. However, in other embodiments an aperture (e.g. 76 as shown in connection with Figure 9) could otherwise be incorporated. Like the previous embodiments, the anchor pad 28 has a rectangular outer perimeter and also extends across a majority of the die.

Figure 19 is a plan view of the integral drain clip and offset support 130.

As shown in connection with Figure 20, the leg 106 comprises three perpendicular bends: a first bend 52 adjacent the anchor pad 28, a second bend 112 provided at a first end of the U-shaped portion 110 and a third bend 114 provided at an opposing end of the U-shaped portion 110.

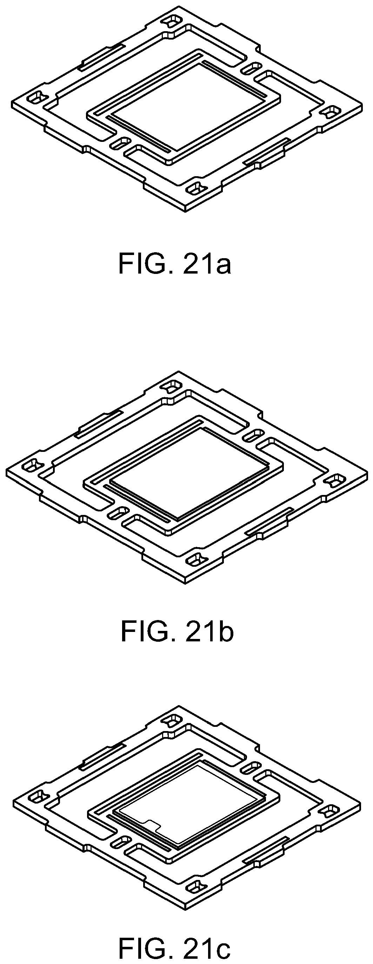

Turning to Figures 21a-i, a method of manufacturing the semiconductor package 102 is schematically indicated. Of note, these method steps share many details and features in common with Figures 11a-i, as described in connection with the semiconductor package 2a, which will not be repeated here for brevity. Instead, only the differences will be described in detail.

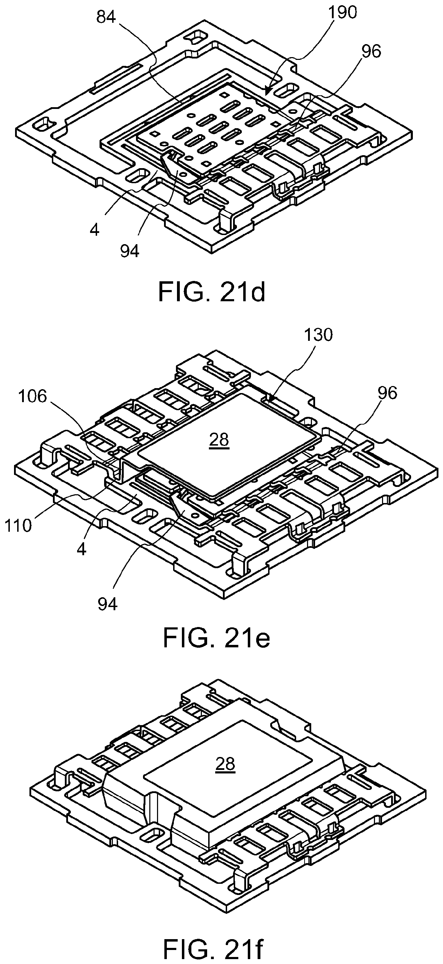

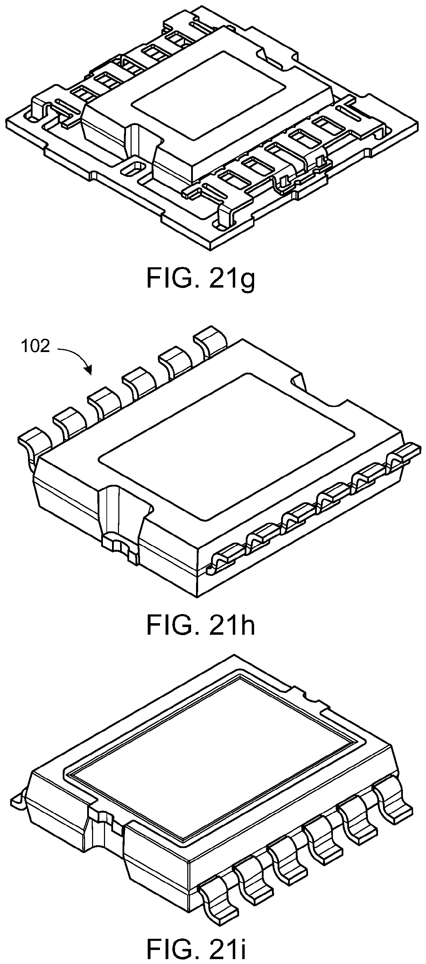

The steps shown in Figures 21 a-c correspond exactly to those shown in Figures 11a-c. However, third and fourth pads 48, 50, as shown in Figure 11a, are omitted in Figure 21a. This is owing to the different embodiment of integral drain clip and offset support 130, used in the semiconductor package 102, being attached to only the second pad 84.

Turning to Figure 21d, this is the first method step which deviates slightly from corresponding step shown in Figure 11d. In Figure 21d a connector 190 is coupled to the subassembly (i.e. specifically coupled to the die paddle 4). However, unlike the connector 90 shown in Figure 11d, the connector 190 does not comprise a drain clip. Instead, the connector 190 comprises only a gate clip 94 and a source clip 96. Like Figure 11d, the gate and source clips 94, 96 are in a conjoined state in Figure 21d, and are separated from one another in a subsequent step. As such, the connector 190 is a single-piece connector as attached in Figure 21d. As shown in Figure 21d, the second pad 84 is still exposed after the connector 190 has been attached.

Turning to Figure 21e, a step is shown in which the integral drain clip and offset support 130 is attached (e.g. to the die paddle 4). The integral drain clip and offset support 130 is coupled to the die paddle 4 by the second pad 84 (not visible in Figure 21e but shown in Figure 21d). Specifically, the U-shaped portion 110 of the leg 106 contacts the second pad 84. In contrast to the subassembly shown in Figure 11d, in Figure 21d the drain clip 92 is thus incorporated in the integral offset support 130. Furthermore, the anchor pad 28 extends across, and over, the gate and source clips 94, 96. In other embodiments it will be appreciated that the connector 190 and integral drain clip and support 130 may be attached simultaneously. However, for ease of installation, particularly given that the anchor pad 28 preferably overlaps the gate clip 96 (and so connector 190), at least partly, it is preferred that the integral drain clip and offset support 130 be coupled to the die paddle 4 after the connector 190 has been coupled to the die paddle 4.

Turning to Figure 21f, like that described in connection with Figure 11f a moulding step is shown in which an encapsulant 8 is moulded at least partly over the die and various other components of the semiconductor package 102. Owing to the geometry of the mould (not shown in Figure 21f), the anchor pad 28 remains exposed even after moulding (i.e. the encapsulant does not cover the anchor pad 28).

Figures 21g-i correspond generally to steps Figure 11g-i, and will therefore not be described in detail. That said, in the finalised, singulated semiconductor package 102 shown in Figures 21h and 21i, the finished product is identical to that shown for the semiconductor package 2a of Figures 11h and 11i, save for the aperture in anchor pad 28a.

Providing the integral offset support and drain clip 130 is advantageous for a number of reasons. The efficiency of manufacturing can be improved by virtue of combining the anchor pad 28 with the drain clip. Of note, it is preferable that the anchor pad only be incorporated with the drain clip, as opposed to the gate and or source clips, because incorporating the anchor pad as part of the source clip can be found to increase the RDS of the package (e.g. resistance) and reduce the performance accordingly.

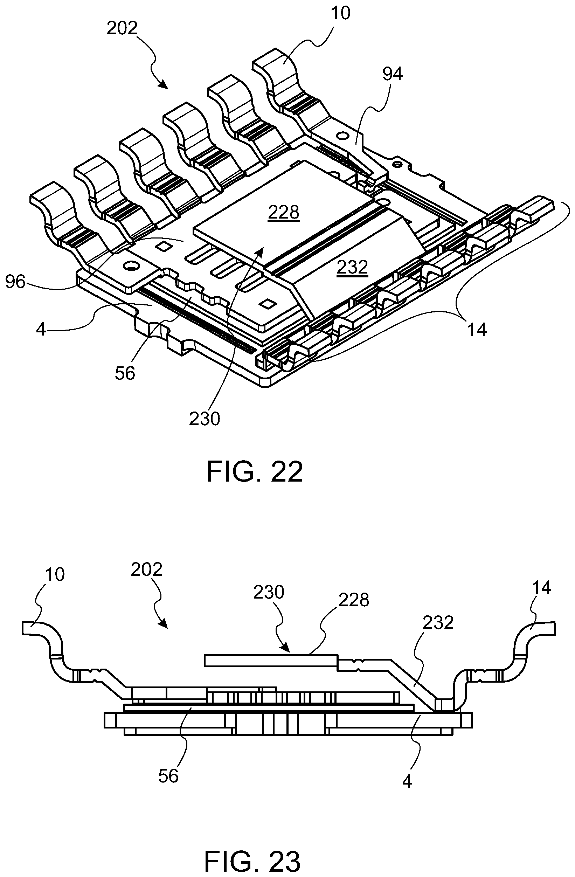

Turning to Figure 22, a perspective view of a semiconductor package 202 according to another embodiment is provided, with an encapsulant omitted. The semiconductor package 202 shows many features in common with the semiconductor package 102 shown and described in connection with Figures 12 to 16. Much of the previous description therefore also applies here, and only the differences will be described in detail.

The semiconductor package 202 comprises an integral drain clip and offset support 230. The integral drain clip and offset support 230 comprises an anchor pad 228 which is formed of a solid body of material (but could incorporate an aperture in some embodiments). Like the other embodiments, the anchor pad 228 extends across at least part of the die 56. However, unlike the previous embodiments the anchor pad 228 is comparatively smaller and extends across only part of the die 56 (i.e. as opposed to extending across a majority of the die 56). Furthermore, a leg 232 which extends from the anchor pad 228 does not comprise a substantially perpendicular bend. Instead, the leg 232 extends at a shallower angle (e.g. 45 to 60 degrees). However, save for this difference, the semiconductor package 202 otherwise shares many features in common with the earlier embodiments. A slight height difference is shown between the anchor pad 228 and pads of the gate and drain 10, 14. This may be achieved by grinding the encapsulant to expose the anchor pad 228.

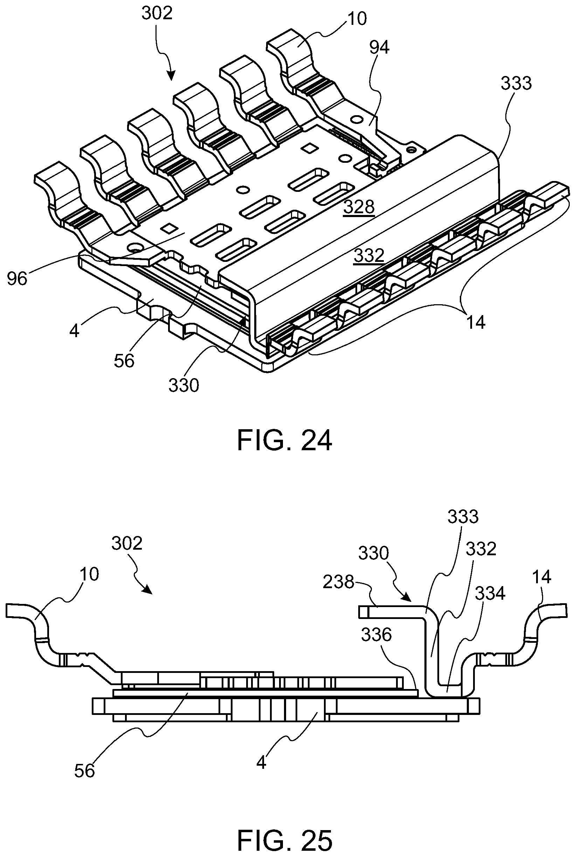

Figure 24 is a perspective view of a further embodiment of semiconductor package 302. Semiconductor package 302 shares various features in common with the semiconductor package 302 shown in Figures 22 and 23 and the semiconductor package 102 shown in Figures 12-16. Much of the previous description therefore applies equally, and only the differences will be described in detail.

The semiconductor package 302 comprises an integral drain clip and offset support 330. The integral drain clip and offset support 330 comprises an anchor pad 328 which extends across at least part of the die 56. Furthermore, a leg 332 extends from the anchor pad 328. The leg 332 comprises a substantially perpendicular bend 333 proximate the anchor pad 328. A U-shaped portion 334 is disposed at the other end of the leg 332. The U-shaped portion defines an attachment portion by which the integral clip and offset support 330 is attachable to the die paddle 4.

The anchor pad 328 does not extend across a majority of the die 56, but instead extends across only part of it (e.g. less than around 50% of the surface area of the die, more preferably less than around 30%). Owing to the single leg 332, the integral offset support 330 also has a cantilever design. The anchor pad 328 extends along an entire long edge 336 of the die 56.

Throughout this document, any bend defined by the offset support or integral drain clip and offset support may comprise one or more apertures. The apertures may be through-holes. Advantageously the apertures facilitate the forming of the bend when the component is manufactured. The offset support, and integral drain clip and offset support, is preferably manufactured from copper or a copper alloy. The offset support, and integral drain clip and offset support, is preferably manufactured using a stamping or forming process.

The invention described herein may be used in conjunction with range of semiconductor packages including: gallium nitride devices, silicon carbide devices, metal-oxide-semiconductor devices, and clip-bonded products.

## Claims

1. A semiconductor package for a printed circuit board, PCB, comprising:
a die paddle;
a die coupled to the die paddle;
a connector coupled to the die, the connector comprising a plurality of leads for attachment to the PCB;
an anchor pad for attachment to the PCB; and
an encapsulant which at least partly surrounds the die; wherein
the anchor pad extends across at least part of the die.

2. The semiconductor package of claim 1, wherein the anchor pad is coupled to a drain terminal.

3. The semiconductor package of claim 2, wherein the anchor pad is electrically connected to the drain terminal.

4. The semiconductor package according to any preceding claim, wherein the anchor pad is a solid body of material.

5. The semiconductor package according to any one of claims 1 to 3, wherein the anchor pad comprises an aperture.

6. The semiconductor package according to any preceding claim, wherein the anchor pad has a substantially rectangular outer perimeter.

7. The semiconductor package according to any preceding claim, wherein the anchor pad extends across a majority of the die.

8. The semiconductor package according to any preceding claim, wherein one or more legs extend from the anchor pad.

9. The semiconductor package according to claim 8, wherein two legs extend from opposing sides of the anchor pad.

10. The semiconductor package according to claims 8 or 9, wherein the one or more legs comprise a substantially perpendicular bend.

11. The semiconductor package according to any preceding claim, dependent directly or indirectly upon claim 3, wherein the anchor pad is integral with a drain clip.

12. A method of manufacturing the semiconductor package of any preceding claim, comprising:
coupling the die to the die paddle;
coupling the connector to the die;
coupling the anchor pad to the die paddle; and
moulding the encapsulant at least partly over the die.

13. A method of attaching the semiconductor package according to any one of claims 1 to 11 to the PCB, the method comprising:
applying solder to the plurality of leads and the anchor pad or applying solder to a plurality of positions on the PCB; and
coupling the plurality of leads and the anchor pad to the PCB to attach the semiconductor package to the PCB.

14. An offset support for a semiconductor package, comprising:
an anchor pad for attachment to a printed circuit board, PCB;
one or more legs extending from the anchor pad, the one or more legs having an attachment portion, substantially parallel to the anchor pad, for attachment to a die paddle.

15. An integral drain clip and offset support for a semiconductor package, comprising:
an anchor pad for attachment to a printed circuit board, PCB;
one or more legs extending from the anchor pad, the one or more legs having an attachment portion, substantially parallel to the anchor pad, for attachment to a die paddle; and
one or more leads defining at least part of a drain clip of the semiconductor package.
